# EUROPÄISCHE PATENTSCHRIFT

(11) **EP 2 817 835 B1**
(45) Veröffentlichungstag und Bekanntmachung des Hinweises auf die Patenterteilung: **27.07.2016**
(21) Anmeldenummer: 13707133.8
(22) Anmeldetag: 19.02.2013
(51) Int. Cl.: H01L 41/047, H01L 41/083, H01L 41/293

(54) **VERFAHREN ZUR HERSTELLUNG EINER ELEKTRISCHEN KONTAKTIERUNG EINES VIELSCHICHTBAUELEMENTS**
METHOD FOR PRODUCING AN ELECTRIC CONTACT OF A MULTILAYER COMPONENT
PROCÉDÉ POUR PRODUIRE UNE MISE EN CONTACT ÉLECTRIQUE D'UN COMPOSANT MULTICOUCHE

(30) Priorität: 24.02.2012 DE 102012101506
(43) Veröffentlichungstag der Anmeldung: 31.12.2014
(73) Patentinhaber: Epcos AG, 81669 München (DE)
(72) Erfinder: SOMITSCH, Dieter, A-8522 Groß St. Florian (AT); RINNER, Franz, A-8530 Deutschlandsberg (AT); GALLER, Martin, A-8401 Karlsdorf (AT); RAMLER, Johann, A-8523 Frauental (AT); GABL, Reinhard, A-6330 Kufstein (AT); BRUNNER, Sebastian, A-8042 Graz (AT)
(74) Vertreter: Epping - Hermann - Fischer
(86) Internationale Anmeldenummer: PCT/EP2013/053265
(87) Internationale Veröffentlichungsnummer: WO 2013/124267

(56) Entgegenhaltungen:
- DE-A1-102009 017 434
- JP-A- H0 354 876
- JP-A- H06 232 466
- JP-A- 2005 183 478
- US-A1- 2005 179 345

## Beschreibung

Es wird ein Verfahren zur Herstellung einer elektrischen Kontaktierung eines Vielschichtbauelements, sowie ein Vielschichtbauelement mit einer elektrischen Kontaktierung angegeben. Beispielsweise ist das Bauelement ein Piezoaktor, der zum Betätigen eines Einspritzventils in einem Kraftfahrzeug eingesetzt werden kann.

Aus der Druckschrift DE 10 2007 058 873 A1 geht ein Piezoaktor aufweisend ein photostrukturierbares Isoliermaterial hervor. Aus der Druckschrift DE 10 2006 003 070 B3 geht ein Piezoaktor hervor, bei dem ein Isoliermaterial mittels eines Lasers strukturiert wird.

Aus der Druckschrift US 2005/179345 A1 geht ein Verfahren zur Herstellung einer Anordnung piezoelektrischer Elemente hervor, bei dem eine Photolackmaske auf eine Außenseite einer Vielschichtstruktur aufgetragen und photolithographisch strukturiert wird. Anschließend werden mithilfe der strukturierten Photolackmaske Isolierstreifen über jeder zweiten Innenelektrode aufgebracht. Danach wird ein elektrisch leitfähiges Material aufgebracht.

Die Druckschriften JP 2005 183478 A, DE 10 2009 017434 A1, JP H03 54876 A und JP H06 232466 A zeigen weitere Verfahren zur Kontaktierung elektrischer Bauelemente.

Es ist eine zu lösende Aufgabe, ein verbessertes Verfahren zur Herstellung einer elektrischen Kontaktierung eines Vielschichtbauelements und ein Vielschichtbauelement mit einer verbesserten elektrischen Kontaktierung anzugeben.

Es wird ein Verfahren zur Herstellung einer elektrischen Kontaktierung eines Vielschichtbauelements angegeben. Das Verfahren umfasst in einem Schritt A) die Bereitstellung eines Grundkörpers des Vielschichtbauelements mit internen Elektrodenschichten. Des Weiteren werden in einem Schritt B) ein Isoliermaterial, ein elektrisch leitfähiges Material und ein photoempfindliches Material bereitgestellt. In einem Schritt C) werden vorzugsweise das Isoliermaterial und das elektrisch leitfähige Material auf einer Außenseite des Grundkörpers zur abwechselnden Kontaktierung der internen Elektrodenschichten strukturiert angeordnet, wobei die strukturierte Anordnung durch das photoempfindliche Material hergestellt wird.

Erfindungsgemäß nach dem unabhängigen Verfahrensanspruch 1 wird zuerst das elektrisch leitfähige Material aufgetragen, danach das photoempfindliche Material aufgetragen und danach das Isoliermaterial aufgetragen.

Der Grundkörper kann einen Stapel aus dielektrischen Schichten aufweisen. Beispielsweise sind dielektrische Schichten und interne Elektrodenschichten entlang einer Stapelrichtung gestapelt. Die Stapelrichtung entspricht vorzugsweise der Längsrichtung des Grundkörpers. Vorzugsweise sind dielektrische Schichten und interne Elektrodenschichten alternierend übereinander gestapelt.

Die dielektrischen Schichten können ein piezoelektrisches Material, zum Beispiel ein keramisches Material, aufweisen. Zur Herstellung des Grundkörpers können Grünfolien verwendet werden, auf die zur Bildung von internen Elektrodenschichten beispielsweise eine Metallpaste aufgebracht wird. Beispielsweise wird die Metallpaste in einem Siebdruckverfahren aufgebracht. Die Metallpaste kann Kupfer enthalten. Beispielsweise werden daraus interne Elektrodenschichten gebildet, die Kupfer als Hauptbestandteil enthalten. Alternativ kann die Metallpaste Silber-Palladium enthalten, wobei daraus interne Elektrodenschichten gebildet werden können, die Silber-Palladium als Hauptbestandteil enthalten. Nach dem Aufbringen der Metallpaste werden die Folien vorzugsweise gestapelt, verpresst und gemeinsam gesintert, sodass ein monolithischer Sinterkörper entsteht. Vorzugsweise wird der Grundkörper des Bauelements durch einen monolithischen Sinterkörper gebildet, beispielsweise durch einen wie oben beschrieben hergestellten Sinterkörper.

Beispielsweise ist das Vielschichtbauelement als piezoelektrisches Bauelement, zum Beispiel als Piezoaktor, ausgebildet. Bei einem Piezoaktor dehnen sich beim Anlegen einer Spannung an die internen Elektrodenschichten zwischen den internen Elektrodenschichten angeordnete piezoelektrische Schichten aus, sodass ein Hub des Piezoaktors erzeugt wird. Das Vielschichtbauelement kann auch als ein anderes Bauelement ausgebildet sein, beispielsweise als Vielschichtkondensator.

Als "piezoelektrische Schicht" wird vorzugsweise ein Abschnitt des Stapels bezeichnet, der ein piezoelektrisches Material aufweist und in Stapelrichtung von zwei benachbarten internen Elektrodenschichten begrenzt wird. Eine piezoelektrische Schicht kann aus einer oder mehreren piezoelektrischen Lagen gebildet sein, die entlang der Stapelrichtung übereinander angeordnet sind. Beispielsweise kann eine piezoelektrische Lage aus einer Grünfolie hergestellt sein. Eine piezoelektrische Schicht kann auch nur eine einzige piezoelektrische Lage aufweisen.

Das Vielschichtbauelement ist vorzugsweise ein vollaktives Vielschichtbauelement. Bei einem vollaktiven Vielschichtbauelement erstrecken sich die internen Elektrodenschichten über den gesamten Querschnitt des Grundkörpers. Die dielektrischen Schichten sind somit vollständig von den internen Elektrodenschichten bedeckt. Das Vielschichtbauelement ist insbesondere frei von inaktiven Zonen zwischen benachbarten Elektrodenschichten. Als inaktive Zone bezeichnet man einen Bereich zwischen zwei benachbarten Elektrodenschichten unterschiedlicher Polarität, in dem sich die Elektrodenschichten nicht überlappen.

Zum Anlegen einer Spannung zwischen in Stapelrichtung benachbarten internen Elektrodenschichten sind vorzugsweise wenigstens zwei Außenelektroden vorgesehen. Beispielsweise sind zwei Außenelektroden auf gegenüberliegenden Außenseiten des Grundkörpers angeordnet. Vorzugsweise stehen die Außenelektroden mit dem Isoliermaterial und dem elektrisch leitfähigen Material in mechanischem Kontakt. Vorzugsweise sind die internen Elektrodenschichten in Stapelrichtung abwechselnd mit einer der Außenelektroden elektrisch verbunden und von der anderen Außenelektrode elektrisch isoliert. Diese abwechselnde elektrische Kontaktierung wird vorzugsweise durch die strukturierte Anordnung von Isoliermaterial und elektrisch leitfähigem Material erzielt.

Das Isoliermaterial und das elektrisch leitfähige Material sind vorzugsweise direkt auf der Außenseite des Grundkörpers aufgebracht. Vorzugsweise sind das Isoliermaterial und das elektrisch leitfähige Material in direktem mechanischem Kontakt mit den internen Elektrodenschichten. Vorzugsweise sind das Isoliermaterial und das elektrisch leitfähige Material in Stapelrichtung abwechselnd über den internen Elektrodenschichten angeordnet. Beispielsweise sind das Isoliermaterial und das elektrisch leitfähige Material streifenförmig über den internen Elektrodenschichten angeordnet. Dadurch wird beispielsweise eine interne Elektrodenschicht auf einer Außenseite des Grundkörpers vollständig von Isoliermaterial oder von elektrisch leitfähigem Material bedeckt. Alternativ wird nur ein Teilbereich der internen Elektrodenschichten von Isoliermaterial oder von elektrisch leitfähigem Material bedeckt.

In einer bevorzugten Ausführungsform wird das Isoliermaterial in Form von Isolationsstegen auf die internen Elektrodenschichten aufgetragen. Vorzugsweise verlaufen die Isolationsstege senkrecht zur Stapelrichtung. In einer bevorzugten Ausführungsform ist die Breite wenigstens eines Isolationsstegs in Stapelrichtung größer als ein Abstand zweier benachbarter interner Elektrodenschichten. In einer bevorzugten Ausführungsform ist auf einer Außenseite jeweils eine Vielzahl von Isolationsstegen angeordnet. Vorzugsweise wird das elektrisch leitfähige Material in Form von Kontaktstegen auf die internen Elektrodenschichten aufgetragen. Vorzugsweise wechseln sich Kontaktstege und Isolationsstege in Stapelrichtung ab. In einer bevorzugten Ausführungsform ist auf einer Außenseite jeweils eine Vielzahl von Kontaktstegen angeordnet.

Das Isoliermaterial weist vorzugsweise ein elektrisch isolierendes Material auf. Das Isoliermaterial kann beispielsweise Glas, Keramikpulver oder einen organischen Isolierlack enthalten. Das Isoliermaterial kann beispielsweise mittels Laminierens, Bedruckens oder Sprühens aufgetragen werden. Vorzugsweise wird das Isoliermaterial als Schicht aufgetragen.

Das elektrisch leitfähige Material kann beispielsweise mittels Sputterns aufgebracht werden. Alternativ kann das elektrisch leitfähige Material als Metallpaste aufgebracht werden, welche anschließend eingebrannt wird. Alternativ kann das elektrisch leitfähige Material einen Leitkleber aufweisen. Das elektrisch leitfähige Material kann beispielsweise ein metallhaltiges oder ein metallisches Material sein. Vorzugsweise wird das elektrisch leitfähige Material als Schicht aufgetragen.

Vorzugsweise wird in einem Verfahrensschritt das photoempfindliche Material auf einer Außenseite des Grundkörpers des Vielschichtbauelements aufgetragen und strukturiert. Vorzugsweise wird das photoempfindliche Material zur Herstellung der strukturierten Anordnung von Isoliermaterial und elektrisch leitfähigem Material auf mindestens einer Außenseite des Grundkörpers aufgetragen und strukturiert.

Vorzugsweise wird das photoempfindliche Material als Schicht aufgetragen. Das photoempfindliche Material wird bevorzugt auf zwei gegenüberliegenden Außenseiten des Grundkörpers aufgetragen und strukturiert. Vorzugsweise wird das photoempfindliche Material so strukturiert, dass nach der Strukturierung zumindest ein Teilbereich über jeder zweiten internen Elektrodenschicht auf der Außenseite des Grundkörpers frei von photoempfindlichem Material ist.

Das photoempfindliche Material wird vorzugsweise mittels Lithografie strukturiert. Insbesondere kann das photoempfindliche Material als ein zu strukturierendes Material verstanden werden, dass durch Photo- bzw. Laserlithografie strukturierbar ist.

Beispielsweise erfolgt eine Strukturierung des photoempfindlichen Materials mittels Photolithografie. Die Photolithografie beruht auf dem Prinzip, dass ein photoempfindliches Material durch Photobelichtung strukturiert wird. Durch die Photobelichtung kann eine lokale Änderung der chemischen Eigenschaften des photoempfindlichen Materials stattfinden. Beispielsweise kann ein photoempfindliches Material durch Belichtung ausgehärtet werden. Die nicht ausgehärteten Bereiche können anschließend entfernt werden. Beispielsweise können die belichteten Bereiche durch ein Lösungsmittel entfernt werden, welches nur die belichteten, nicht jedoch die unbelichteten Bereiche des photoempfindlichen Materials auflöst. Alternativ kann das Lösungsmittel die unbelichteten Bereiche auflösen, nicht jedoch die belichteten Bereiche.

Beispielsweise umfasst das photoempfindliche Material einen Fotolack. Vorzugsweise unterscheidet sich das photoempfindliche Material vom Isoliermaterial, insbesondere durch seine chemische Zusammensetzung.

Das photoempfindliche Material kann als Maske für die strukturierte Anordnung des Isoliermaterials und des elektrisch leitfähigen Materials dienen. Beispielsweise wird durch das photoempfindliche Material das Isoliermaterial oder das elektrisch leitfähige Material gezielt nur an vorgegebenen Stellen auf der Außenseite des Grundkörpers aufgetragen, z. B. über jeder zweiten internen Elektrodenschicht. Alternativ wird durch das photoempfindliche Material das Isoliermaterial oder das elektrisch leitfähige Material gezielt an vorgegebenen Stellen, z. B. über jeder zweiten internen Elektrodenschicht, abgetragen.

Vorzugsweise wird der Grundkörper des Vielschichtbauelements vor der Strukturierung des photoempfindlichen Materials vermessen, um eine genaue Positionierung des Isoliermaterials und des elektrisch leitfähigen Materials zu erzielen. Beispielsweise wird der Grundkörper mittels optischer Inspektion vermessen.

Durch diese Vermessung ist es beispielsweise möglich, die Lage der internen Elektrodenschichten innerhalb des Stapels zu ermitteln. Beispielsweise kann die Strukturierung des photoempfindlichen Materials auf unterschiedliche Stapelhöhen und unterschiedliche Dicken der dielektrischen Schichten angepasst werden. Somit kann die strukturierte Anordnung von Isoliermaterial und elektrisch leitfähigem Material individuell an den Grundkörper angepasst werden. Dadurch kann gewährleistet werden, dass jede interne Elektrodenschicht auf einer Außenseite des Grundkörpers ausreichend mit Isoliermaterial oder mit elektrisch leitfähigem Material bedeckt wird.

Die Strukturierung des photoempfindlichen Materials kann mittels einer Belichtungsmaske erfolgen. Die Belichtungsmaske ist vorzugsweise so ausgebildet, dass bei einer Belichtung Bereiche des photoempfindlichen Materials, die über jeder zweiten internen Elektrodenschicht auf einer Außenseite des Grundkörpers liegen, belichtet werden. Die Bereiche über den anderen internen Elektrodenschichten werden nicht belichtet.

Die Belichtungsmaske kann entsprechend dem Ergebnis der vorhergegangenen Vermessung des Grundkörpers ausgewählt werden. Dabei kann die Belichtungsmaske individuell auf die Stapelhöhe des Grundkörpers und auf die Lage der internen Elektrodenschichten angepasst sein. Beispielsweise kann dafür eine passende Belichtungsmaske aus einem Set von Belichtungsmasken ausgewählt werden. Die Auswahl erfolgt beispielsweise nach einer sogenannten Klasseneinteilung. Alternativ kann über eine sogenannte Projektionsbelichtung der Abbildungsmaßstab der abgebildeten Belichtungsmaske auf die Stapelhöhe angepasst werden. Dabei kann der Abstand zwischen dem Grundkörper und der Belichtungsmaske so eingestellt werden, dass sich der richtige Abbildungsmaßstab ergibt.

Beim Herstellungsprozess des Grundkörpers kann es, z. B. aufgrund von Produktionstoleranzen, dazu kommen, dass die Abstände zwischen den internen Elektrodenschichten unterschiedlich sind. Solche unterschiedlichen Abstände können beispielsweise durch Pressverzug oder unterschiedlichen Sinterschwund während der Herstellung des Grundkörpers verursacht werden. In diesem Fall ist es möglich, dass die Struktur der Belichtungsmaske nicht genau mit der Anordnung der internen Elektrodenschichten übereinstimmt. Dadurch besteht die Gefahr, dass die internen Elektrodenschichten auf einer Außenseite des Grundkörpers nicht alternierend mit Isoliermaterial und mit elektrisch leitfähigem Material bedeckt werden, sondern dass beispielsweise zwei benachbarte interne Elektrodenschichten auf einer Außenseite des Grundkörpers von elektrisch leitfähigem Material bedeckt sind. Dadurch besteht die Gefahr von Kurzschlüssen.

Um die Gefahr von Kurzschlüssen im Betrieb zu vermeiden, wird das Isoliermaterial vorzugsweise so strukturiert, dass die Breite eines Isolationsstegs in Stapelrichtung größer ist als ein Abstand zwischen zwei benachbarten internen Elektrodenschichten. Vorzugsweise ist die Breite des Isolationsstegs mindestens so groß wie der Abstand zweier benachbarter interner Elektrodenschichten zuzüglich der Dicke einer internen Elektrodenschicht. Der Abstand zweier benachbarter interner Elektrodenschichten wird dabei jeweils von der Mitte der Elektrodenschichten aus gemessen.

Vorzugsweise ist der Isolationssteg um eine Breite x größer als der Abstand zweier benachbarter interner Elektrodenschichten. Die Breite x wird auch als Überlapp bezeichnet. Vorzugsweise ist der Überlapp des Isolationsstegs derart gewählt, dass eine zuverlässige Isolierung der internen Elektrodenschichten gewährleistet ist. Vorzugsweise wird dadurch auch bei einer ungenauen Positionierung des Isolationsstegs auf der Außenseite mindestens jede zweite interne Elektrodenschicht auf einer Außenseite des Grundkörpers mit Isoliermaterial bedeckt. Vorzugsweise ist die Breite x kleiner als der Abstand zwischen zwei internen Elektrodenschichten.

Im dem Fall, dass aufgrund von unterschiedlichen Abständen zwischen den internen Elektrodenschichten die Struktur der Belichtungsmaske nicht genau mit der Anordnung der internen Elektrodenschichten übereinstimmt, kann es aufgrund der Breite der Isolationsstege vorkommen, dass auf derselben Außenseite zwei oder mehrere benachbarte interne Elektrodenschichten mit Isoliermaterial bedeckt werden. Dadurch kann eine Fehlkontaktierung des Vielschichtbauelements auftreten, so dass eine oder mehrere Elektroden nicht kontaktiert werden. Solche fehlkontaktierten Bauelemente können durch eine elektrische Messung identifiziert und aussortiert werden. Somit kann das Bauelement schon vor der Auslieferung und Inbetriebnahme aussortiert werden, so dass ein Ausfall des Bauelements während des Betriebs vermieden wird.

Beispielsweise beträgt die Breite des Isolationsstegs in Stapelrichtung wenigstens die Breite des Kontaktstegs in Stapelrichtung multipliziert mit dem Faktor 1,1. Beispielsweise beträgt die Breite des Isolationsstegs in Stapelrichtung die Breite des Kontaktstegs in Stapelrichtung multipliziert mit dem Faktor 2,0. Vorzugsweise beträgt die Breite des Isolationsstegs in Stapelrichtung die Breite des Kontaktstegs in Stapelrichtung multipliziert mit einem Faktor 1,3 bis 1,5.

Die Gefahr einer Fehlkontaktierung tritt vor allem bei einer Strukturierung mittels Maskentechnik auf. Bei einer Strukturierung mittels eines selbstjustierenden Verfahrens ist die Gefahr einer Fehlkontaktierung reduziert.

Alternativ können die gewünschten Bereiche eines zu strukturierenden Materials durch gezieltes Abfahren belichtet werden. Dies kann zum Beispiel mit einem Laser erfolgen. Man spricht dabei von Laserlithografie. Vorzugsweise wird auch beim Laserlithografieverfahren ein Isolationssteg mit einem Überlapp aufgetragen.

Das Auftragen des photoempfindlichen Materials erfolgt in einer Ausführungsform vor dem Auftragen des Isoliermaterials und des elektrisch leitfähigen Materials.

Das photoempfindliche Material wird vorzugsweise auf mindestens einer Außenseite des Grundkörpers aufgetragen. Vorzugsweise wird das photoempfindliche Material auf zwei gegenüberliegenden Außenseiten des Grundkörpers aufgetragen. Das photoempfindliche Material kann in einer Ausführungsform direkt auf die Oberfläche des Grundkörpers aufgetragen werden, so dass es in direktem mechanischem Kontakt mit den dielektrischen Schichten und den internen Elektrodenschichten steht.

Anschließend wird das photoempfindliche Material wie vorher beschrieben strukturiert.

Nach der Strukturierung des photoempfindlichen Materials ist vorzugsweise jede zweite interne Elektrodenschicht auf einer Außenseite des Grundkörpers mit photoempfindlichem Material bedeckt. Die übrigen Elektrodenschichten sind vorzugsweise frei von photoempfindlichem Material.

Nach der Strukturierung des photoempfindlichen Materials wird beispielsweise Isoliermaterial aufgetragen.

Vorzugsweise wird das Isoliermaterial auf die freiliegenden internen Elektrodenschichten aufgetragen. Das Isoliermaterial kann so aufgetragen werden, dass sowohl die freiliegenden internen Elektrodenschichten, als auch das photoempfindliche Material mit Isoliermaterial bedeckt sind. Nach dem Auftragen des Isoliermaterials sind die internen Elektrodenschichten vorzugsweise abwechselnd mit photoempfindlichem Material und mit Isoliermaterial bedeckt.

In einem weiteren, insbesondere nachfolgenden Verfahrensschritt kann das photoempfindliche Material entfernt werden. Dadurch werden vorzugsweise freiliegende interne Elektrodenschichten gebildet.

Beispielsweise liegen die internen Elektrodenschichten zumindest teilweise frei.

Beispielsweise kann das photoempfindliche Material in einem so genannten Lift-Off-Verfahren entfernt werden. Für die Anwendung des Lift-Off-Verfahrens wird beispielsweise das photoempfindliche Material so strukturiert, dass es eine negative Flanke aufweist. Auf die negative Flanke des photoempfindlichen Materials wird kein Isoliermaterial aufgetragen. Diese negative Flanke kann in einem späteren Verfahrensschritt als Angriffsfläche für die Entfernung des photoempfindlichen Materials dienen. Zum Beispiel kann an dieser negativen Flanke in einem späteren Verfahrensschritt ein Lösungsmittel angreifen, wodurch das photoempfindliche Material entfernt werden kann. Dabei kann an dem photoempfindlichen Material haftendes Isoliermaterial zusammen mit dem photoempfindlichen Material entfernt werden.

Alternativ kann vor der Entfernung des photoempfindlichen Materials das Isoliermaterial soweit abgetragen werden, dass zumindest das photoempfindliche Material nicht mehr von Isoliermaterial bedeckt ist. Das Abtragen des Isoliermaterials kann beispielsweise durch Sandstrahlen, Schleifen oder Fräsen erfolgen. Anschließend kann das photoempfindliche Material durch ein Lösungsmittel entfernt werden.

Vorzugsweise ist das photoempfindliche Material nun vollständig von dem Grundkörper des Vielschichtbauelements entfernt. Vorzugsweise ist nach der Entfernung des photoempfindlichen Materials jede zweite interne Elektrodenschicht auf einer Außenseite des Grundkörpers mit Isoliermaterial bedeckt. Vorzugsweise ist jede zweite interne Elektrodenschicht auf einer Außenseite des Grundkörpers vollständig mit Isoliermaterial bedeckt. Vorzugsweise sind die anderen Elektrodenschichten zumindest teilweise frei von Isoliermaterial.

In einem weiteren, insbesondere nachfolgenden Verfahrensschritt wird vorzugsweise das elektrisch leitfähige Material auf die freiliegenden internen Elektrodenschichten aufgetragen.

Dazu wird das elektrisch leitfähige Material vorzugsweise flächig auf die Außenseite des Grundkörpers aufgetragen, auf der das Isoliermaterial strukturiert angeordnet ist. Dadurch wird jede zweite interne Elektrodenschicht auf einer Außenseite des Grundkörpers mit elektrisch leitfähigem Material kontaktiert, während die übrigen internen Elektrodenschichten auf der Außenseite des Grundkörpers mit Isoliermaterial bedeckt sind.

Das elektrisch leitfähige Material kann mittels eines vorhergehend beschriebenen Verfahrens aufgetragen werden.

In einer alternativen Ausführungsform des Verfahrens wird das elektrisch leitfähige Material vorzugsweise vor dem Auftragen des Isoliermaterials aufgetragen.

Beispielsweise wird zuerst das photoempfindliche Material auf eine Außenseite des Grundkörpers aufgetragen und strukturiert. Nachfolgend wird elektrisch leitfähiges Material auf das strukturierte photoempfindliche Material aufgetragen.

In einem weiteren, vorzugsweise nachfolgenden Verfahrensschritt kann das photoempfindliche Material entfernt werden. Dadurch werden vorzugsweise freiliegende interne Elektrodenschichten gebildet.

Die Entfernung des photoempfindlichen Materials kann wie vorher beschrieben stattfinden.

Beispielsweise wird das an dem strukturierten photoempfindlichen Material anhaftende elektrisch leitfähige Material zusammen mit dem photoempfindlichen Material entfernt. Dadurch ist vorzugsweise jede zweite interne Elektrodenschicht auf einer Außenseite des Grundkörpers mit elektrisch leitfähigem Material bedeckt. Vorzugsweise sind die anderen Elektrodenschichten auf der Außenseite des Grundkörpers frei von elektrisch leitfähigem Material.

In einem weiteren, insbesondere nachfolgenden Verfahrensschritt wird vorzugsweise Isoliermaterial auf die freiliegenden internen Elektrodenschichten aufgetragen.

Das Isoliermaterial wird vorzugsweise so aufgetragen, dass das elektrisch leitfähige Material nicht mit Isoliermaterial bedeckt ist. Beispielsweise weist das Isoliermaterial eine geringe Haftfähigkeit auf dem elektrisch leitfähigen Material auf. Beispielsweise kann das Isoliermaterial so ausgebildet sein, dass es auf der Oberfläche des Grundkörpers, nicht jedoch auf dem elektrisch leitfähigen Material haftet. Alternativ kann in einem zusätzlichen Verfahrensschritt ein Teil des Isoliermaterials abgetragen werden, so dass das elektrisch leitfähige Material nicht mit Isoliermaterial bedeckt ist. Beispielsweise kann das Isoliermaterial durch Sandstrahlen, Schleifen oder Fräsen abgetragen werden.

In einer weiteren alternativen Ausführungsform des Verfahrens wird wenigstens ein Material aus dem Isoliermaterial und dem elektrisch leitfähigen Material aufgetragen und danach das photoempfindliche Material aufgetragen.

Beispielsweise wird auf die Außenseite des Grundkörpers zunächst Isoliermaterial aufgetragen. Beispielsweise wird das Isoliermaterial als Schicht aufgetragen. Anschließend kann das photoempfindliche Material auf das Isoliermaterial aufgetragen werden.

In einem weiteren, insbesondere nachfolgenden Schritt wird das photoempfindliche Material strukturiert. Beispielsweise wird das photoempfindliche Material mittels Photolithografie strukturiert.

Das photoempfindliche Material wird vorzugsweise so strukturiert, dass sich auf der Außenseite des Grundkörpers oberhalb jeder zweiten internen Elektrodenschicht photoempfindliches Material befindet. Das unter dem photoempfindlichen Material aufgebrachte Material, beispielsweise das Isoliermaterial, bleibt dabei zunächst unverändert.

In einem weiteren, vorzugsweise nachfolgenden Schritt wird das wenigstens eine Material aus dem Isoliermaterial und dem elektrisch leitfähigen Material strukturiert. Vorzugsweise dient das photoempfindliche Material bei der Strukturierung als Maske.

Insbesondere wird eine unter dem photoempfindlichen Material liegende Schicht vorzugsweise so strukturiert, dass jede zweite interne Elektrodenschicht freiliegt und jede andere zweite interne Elektrodenschicht bedeckt ist. Beispielsweise wird eine unter dem photoempfindlichen Material liegende Schicht aus Isoliermaterial strukturiert. Beispielsweise wird die Schicht so strukturiert, dass jede andere zweite interne Elektrodenschicht mit Isoliermaterial bedeckt ist.

Das zuerst aufgetragene Material kann beispielsweise durch ein Ätzverfahren strukturiert werden. Dabei wird nur der Bereich der unter dem photoempfindlichen Material liegenden Schicht entfernt, welcher nicht mit photoempfindlichem Material bedeckt ist. Das photoempfindliche Material kann insbesondere als Ätzstopp fungieren. Alternativ kann die unter dem photoempfindlichen Material liegende Schicht durch ein Lösungsmittel strukturiert werden.

Anschließend kann der Photolack beispielsweise durch ein Lösungsmittel entfernt werden.

Gemäß einer Ausführungsform kann die Strukturierung des photoempfindlichen Materials und des unter dem photoempfindlichen Material aufgebrachten Materials mittels drei verschiedener Lösungsmittel erfolgen. Die verschiedenen Lösungsmittel können verschiedene Materialien selektiv ätzen.

Anschließend kann auf die Außenseite des Grundkörpers zum Beispiel elektrisch leitfähiges Material flächig aufgetragen werden. Das elektrisch leitfähige Material wird vorzugsweise auf die Außenseite des Grundkörpers aufgetragen, auf der das Isoliermaterial strukturiert aufgetragen ist. Das elektrisch leitfähige Material bedeckt vorzugsweise die freiliegenden internen Elektrodenschichten und das Isoliermaterial.

Vorzugsweise ist nun jede zweite interne Elektrodenschicht direkt mit elektrisch leitfähigem Material bedeckt. Die übrigen Elektrodenschichten sind direkt mit Isoliermaterial bedeckt.

Alternativ kann unter dem photoempfindlichen Material elektrisch leitfähiges Material aufgetragen sein. Das photoempfindliche Material wird vorzugsweise wie oben beschrieben strukturiert.

Anschließend wird das elektrisch leitfähige Material vorzugsweise so strukturiert, dass jede zweite interne Elektrodenschicht mit elektrisch leitfähigem Material bedeckt ist. Zum Beispiel kann das elektrisch leitfähige Material in einem Ätzverfahren strukturiert werden. Das strukturierte photoempfindliche Material kann dabei als Ätzstopp fungieren. Nachfolgend wird das photoempfindliche Material entfernt. Anschließend kann Isoliermaterial auf die freiliegenden internen Elektrodenschichten aufgetragen werden.

Vorzugsweise wird das photoempfindliche Material während des Herstellverfahrens zunächst aufgetragen und im Laufe des Verfahrens vollständig entfernt.

Das photoempfindliche Material kann zum Beispiel mit einem Lösungsmittel entfernt werden. Alternativ kann das photoempfindliche Material mittels Fräsen, Sandstrahlen oder Schleifen entfernt werden.

Vorzugsweise dient das photoempfindliche Material während dem Herstellverfahren lediglich als Maske zur strukturierten Anordnung des Isoliermaterials und des elektrisch leitfähigen Materials.

Nach der strukturierten Anordnung von elektrisch leitfähigem Material und Isoliermaterial kann mindestens eine Außenelektrode an den Grundkörper angebracht werden. Bevorzugt werden zwei Außenelektroden angebracht. Die zwei Außenelektroden werden bevorzugt auf zwei gegenüberliegenden Außenseiten des Grundkörpers angebracht, und zwar auf den Außenseiten, auf denen das Isoliermaterial und das elektrisch leitfähige Material strukturiert angeordnet sind. Beispielsweise ist eine Außenelektrode flächig auf eine Außenseite des Grundkörpers aufgebracht. Über die Außenelektroden können die internen Elektrodenschichten elektrisch kontaktiert werden. Vorzugsweise sind die Außenelektroden über das elektrisch leitfähige Material abwechselnd mit den internen Elektrodenschichten in Kontakt.

Des Weiteren wird ein Vielschichtbauelement angegeben, welches einen Grundkörper mit internen Elektrodenschichten sowie ein elektrisch leitfähiges Material und ein Isoliermaterial aufweist. Das Isoliermaterial und das elektrisch leitfähige Material sind zur abwechselnden Kontaktierung der internen Elektrodenschichten auf einer Außenseite des Grundkörpers strukturiert angeordnet. Die strukturierte Anordnung des Isoliermaterials und des elektrisch leitfähigen Materials wird mittels photoempfindlichen Materials hergestellt. Vorzugsweise wird das Vielschichtbauelement gemäß dem vorher beschriebenen Verfahren hergestellt.

Des Weiteren wird ein Vielschichtbauelement angegeben, welches einen Grundkörper mit internen Elektrodenschichten sowie ein Isoliermaterial und ein elektrisch leitfähiges Material aufweist. Vorzugsweise ist das Vielschichtbauelement durch ein wie vorher beschriebenes Verfahren hergestellt. Das Vielschichtbauelement kann jedoch auch durch ein alternatives Verfahren hergestellt sein. Beispielsweise kann das Isoliermaterial als photoempfindliches Material ausgebildet sein. Somit verbleibt beispielsweise ein Teil des photoempfindlichen Materials nach der Photostrukturierung auf der Außenseite des Grundkörpers und dient zur Isolierung der internen Elektrodenschichten.

Vorzugsweise sind das Isoliermaterial und das elektrisch leitfähige Material zur abwechselnden Kontaktierung der internen Elektrodenschichten auf einer Außenseite des Grundkörpers strukturiert angeordnet. Die strukturierte Anordnung des Isoliermaterials wird vorzugsweise mittels Photostrukturierung hergestellt. Vorzugsweise bildet das Isoliermaterial Isolationsstege über internen Elektrodenschichten, wobei eine Breite eines Isolationsstegs in Stapelrichtung größer ist als ein Abstand zweier benachbarter interner Elektrodenschichten. Beispielsweise bildet das elektrisch leitfähige Material Kontaktstege über den internen Elektrodenschichten. Vorzugsweise wechseln sich Kontaktstege und Isolationsstege in Stapelrichtung ab.

Des Weiteren wird ein Verfahren zur Herstellung einer elektrischen Kontaktierung eines Vielschichtbauelements angegeben, wobei ein Grundkörper mit internen Elektrodenschichten bereitgestellt wird. Beispielsweise entspricht das Verfahren dem vorher beschriebenen Verfahren. Es kann jedoch auch ein alternatives Verfahren angewendet werden. Beispielsweise können das Isoliermaterial und das elektrisch leitfähige Material mittels eines Siebdruckverfahrens aufgetragen werden. Vorzugsweise wird ein nicht-selbstjustierendes Verfahren angewendet.

Vorzugsweise wird der Grundkörpers zur Ermittlung der Lage der internen Elektrodenschichten vermessen. Vorzugsweise werden anschließend Isolationsstege zur alternierenden Isolierung der internen Elektrodenschichten aufgetragen, wobei ein Isolationssteg jeweils eine Breite in Stapelrichtung aufweist, welche größer ist als ein Abstand zweier benachbarter interner Elektrodenschichten.

Eine derartige Breite ist besonders vorteilhaft, wenn die Isolationsstege mittels eines nicht-selbstjustierenden Verfahrens auf der Außenseite positioniert werden, da es bei derartigen Verfahren dazu kommen kann, dass die Isolationsstege infolge ungleichmäßigen Abstands der internen Elektrodenschichten ungenau auf den Innenelektroden positioniert sind. Durch die Ausgestaltung der Isolationsstege mit einer Breite größer als der Abstand zweier benachbarter interner Elektrodenschichten kann ein Kurzschluss oder elektrischer Durchbruch benachbarter Elektrodenschichten im Betrieb des Bauelements verhindert werden.

Im Folgenden werden das Verfahren zur Herstellung eines Vielschichtbauelements sowie das Vielschichtbauelement anhand von schematischen und nicht maßstabsgetreuen Figuren erläutert.

Es zeigen:
- Figur 1: eine perspektivische Ansicht eines piezoelektrischen Vielschichtbauelements,
- Figuren 2A bis 2F: Schritte bei der Herstellung des piezoelektrischen Vielschichtbauelements gemäß Figur 1,
- Figuren 3A bis 3E: Schritte eines alternativen Herstellungsverfahrens zur Herstellung des piezoelektrischen Vielschichtbauelements gemäß Figur 1,
- Figuren 4A bis 4F: Schritte eines weiteren Herstellungsverfahrens zur Herstellung des piezoelektrischen Vielschichtbauelements gemäß Figur 1,
- Figuren 5A bis 5C: verschiedene mögliche Positionierungen eines Isolationsstegs bei der Strukturierung des Isoliermaterials,
- Figur 6: ein Vielschichtbauelement mit nicht kontaktierten Bereichen in einer Seitenansicht.

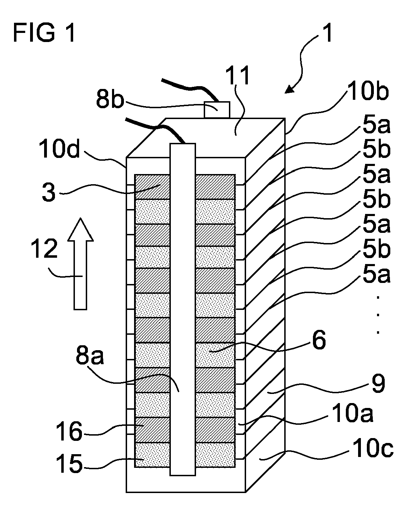

Figur 1 zeigt eine perspektivische Darstellung eines Vielschichtbauelements 1 in Form eines Piezoaktors.

Das Vielschichtbauelement 1 weist einen Grundkörper 11 aus übereinander angeordneten piezoelektrischen Schichten 9 und dazwischen liegenden internen Elektrodenschichten 5a, 5b auf. Der Grundkörper 11 ist als monolithischer Sinterkörper ausgebildet. Die piezoelektrischen Schichten 9 und die internen Elektrodenschichten 5a, 5b sind entlang einer Stapelrichtung 12, die der Längsrichtung des Grundkörpers 11 entspricht, übereinander angeordnet. Dabei sind erste interne Elektrodenschichten 5a und zweite interne Elektrodenschichten 5b zwischen den piezoelektrischen Schichten 9 abwechselnd übereinander angeordnet. Beim Anlegen einer Spannung dehnt sich das Vielschichtbauelement 1 in Stapelrichtung 12 aus.

Die piezoelektrischen Schichten 9 enthalten ein keramisches Material, beispielsweise Blei-Zirkonat-Titanat (PZT) oder eine bleifreie Keramik. Das Keramikmaterial kann auch Dotierstoffe enthalten. Die internen Elektrodenschichten 5a, 5b enthalten beispielsweise Silber-Palladium oder Kupfer.

Zur Herstellung des Vielschichtbauelements 1 werden beispielsweise Grünfolien, die ein Keramikpulver, ein organisches Bindemittel und ein Lösungsmittel enthalten, durch Folienziehen oder Foliengießen hergestellt. Auf einige der Grünfolien wird zur Bildung der internen Elektrodenschichten 5a, 5b eine Elektrodenpaste mittels Siebdruck aufgebracht. Die Grünfolien werden entlang der Stapelrichtung 12 übereinander gestapelt und verpresst. Schließlich wird der Stapel aus piezoelektrischen Grünfolien und internen Elektrodenschichten 5a, 5b gesintert.

Eine piezoelektrische Schicht 9 bezeichnet dabei einen Bereich des Grundkörpers 11, der ein piezoelektrisches Material enthält und in Längsrichtung von zwei benachbarten internen Elektrodenschichten 5a, 5b begrenzt wird. Eine piezoelektrische Schicht 9 kann mehrere Lagen enthalten. Beispielsweise ist eine piezoelektrische Lage aus einer Grünfolie hergestellt.

Das Vielschichtbauelement 1 ist als vollaktiver Piezoaktor ausgebildet. Bei einem vollaktiven Piezoaktor erstrecken sich die internen Elektrodenschichten 5a, 5b an allen Stellen bis zu den Außenseiten 10a, 10b, 10c, 10d des Grundkörpers. Dabei bedecken die internen Elektrodenschichten 5a, 5b die gesamte Querschnittsfläche des Grundkörpers, d.h. die piezoelektrischen Schichten 9 sind vollständig von den internen Elektrodenschichten 5a, 5b bedeckt.

Auf einer ersten Außenseite 10a des Grundkörpers 11 werden die ersten internen Elektrodenschichten 5a, und auf einer gegenüberliegenden zweiten Außenseite 10b die zweiten internen Elektrodenschichten 5b kontaktiert. Durch diese abwechselnde Kontaktierung der internen Elektrodenschichten 5a, 5b wird eine Spannung zwischen zwei benachbarten internen Elektrodenschichten 5a, 5b erzeugt.

Zur abwechselnden Kontaktierung der internen Elektrodenschichten 5a, 5b sind in dem hier gezeigten Ausführungsbeispiel auf den Außenseiten 10a, 10b des Grundkörpers 11 ein Isoliermaterial 3 und ein elektrisch leitfähiges Material 6 strukturiert angeordnet. Das Isoliermaterial 3 und das elektrisch leitfähige Material 6 sind so angeordnet, dass die internen Elektrodenschichten 5a, 5b auf einer Außenseite 10a, 10b alternierend mit Isoliermaterial 3 und mit elektrisch leitfähigem Material 6 bedeckt sind. Das Isoliermaterial 3 und das elektrisch leitfähige Material 6 sind dabei zum Beispiel streifenförmig auf den internen Elektrodenschichten 5a, 5b angeordnet. Insbesondere bildet das Isoliermaterial 3 Isolationsstege 15 und das elektrisch leitfähige Material 6 Kontaktstege 16 auf den internen Elektrodenschichten 5a, 5b. Beispielsweise sind durch das Isoliermaterial 3 und das elektrisch leitfähige Material 6 annähernd die gesamten Außenseiten 10a, 10b bedeckt. Alternativ ist durch das Isoliermaterial 3 und das elektrisch leitfähige Material 6 jeweils nur ein Teilbereich der Außenseiten 10a, 10b bedeckt.

Die strukturierte Anordnung des Isoliermaterials 3 und des elektrisch leitfähigen Materials 6 wird mit Hilfe eines photoempfindlichen Materials 2 erzeugt. Dazu wird das photoempfindliche Material 2 strukturiert und dient beispielsweise als Maske zur Auftragung des Isoliermaterials 3 bzw. des elektrisch leitfähigen Materials 6. Im Laufe des Herstellverfahrens wird das photoempfindliche Material 2 vollständig vom Vielschichtbauelement 1 entfernt.

Das piezoelektrische Vielschichtbauelement 1 weist zudem eine erste Außenelektrode 8a und eine zweite Außenelektrode 8b auf, welche außen an dem Grundkörper 11 des Vielschichtbauelements 1 angeordnet sind. In dem hier gezeigten Ausführungsbeispiel sind die Außenelektroden 8a, 8b auf gegenüberliegenden Außenseiten 10a, 10b des piezoelektrischen Vielschichtbauelements 1 angeordnet. Die Außenelektroden 8a, 8b verlaufen streifenförmig entlang der Stapelrichtung 12. Die Außenelektroden 8a, 8b enthalten beispielsweise Silber-Palladium oder Kupfer und können als Metallblech auf den Grundkörper 11 aufgebracht und angelötet werden.

Aufgrund der strukturierten Anordnung von Isoliermaterial 3 und elektrisch leitfähigem Material 6, wird auf einer ersten Außenseite 10a jeweils jede erste interne Elektrodenschicht 5a über eine Außenelektrode 8a elektrisch kontaktiert. Die zweiten internen Elektrodenschichten 5b sind von dieser Außenelektrode 8a elektrisch isoliert. Auf der gegenüberliegenden zweiten Außenseite 10b werden die zweiten internen Elektrodenschichten 5b von der Außenelektrode 8b kontaktiert.

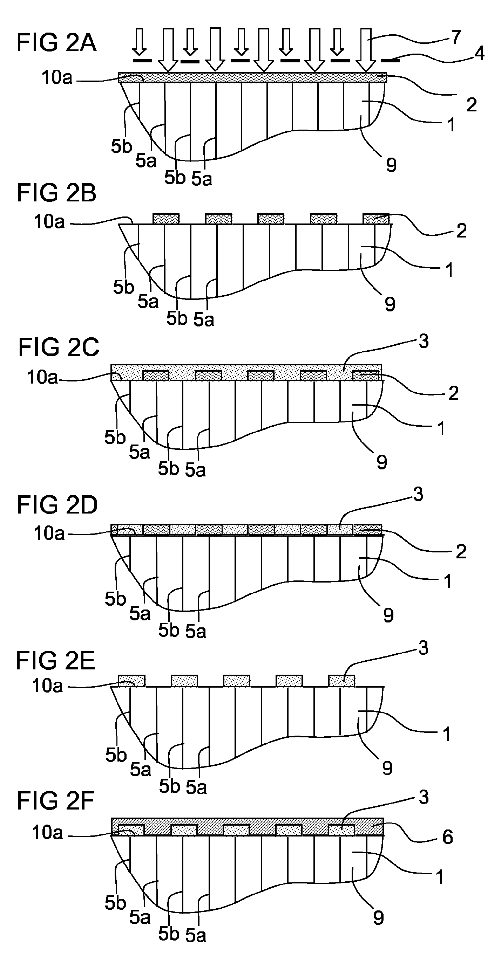

Die Figuren 2A bis 2F zeigen ein Prinzipschema zur Herstellung eines piezoelektrischen Vielschichtbauelements gemäß Figur 1. Die strukturierte Anordnung von Isoliermaterial 3 und elektrisch leitfähigem Material 6 auf einer Außenseite 10a des Vielschichtbauelements 1 wird dabei durch ein photoempfindliches Material 2 hergestellt.

Die Figuren 2A bis 2F zeigen jeweils in einer Seitenansicht einen Ausschnitt eines piezoelektrischen Bauelements in einem Zwischenzustand während der Herstellung des in Figur 1 gezeigten Vielschichtbauelements 1.

Auf einer ersten Außenseite 10a des Vielschichtbauelements 1 wird, wie in Figur 2A gezeigt, ein photoempfindliches Material 2 aufgetragen. Vorzugsweise wird auch auf einer zweiten Außenseite 10b photoempfindliches Material 2 aufgetragen. Das photoempfindliche Material 2 ist zum Beispiel ein Fotolack. Dieser Fotolack wird an den zwei für die Außenelektroden 8 vorgesehenen Außenseiten 10a, 10b aufgebracht.

Vor der Auftragung des photoempfindlichen Materials 2 wird der Grundkörper 11 vermessen, um die genaue Größe des Grundkörpers 11 und die genauen Positionen der internen Elektrodenschichten 5a, 5b zu bestimmen. Diese Vermessung erfolgt beispielsweise durch ein optisches Messverfahren. Mit einer individuell auf den Grundkörper 11 angepassten Belichtungsmaske 4 wird das photoempfindliche Material 2 durch eine Belichtung 7 strukturiert. Dies erfolgt gemäß dem Prinzip der optischen Lithografie. Beispielsweise löst sich das photoempfindliche Material 2 an den belichteten Stellen auf. Alternativ härtet das photoempfindliche Material 2 an den belichteten Stellen aus, während das nicht belichtete photoempfindliche Material 2 leicht entfernt werden kann.

Die Auswahl der Belichtungsmaske 4 kann zum Beispiel aus einem Set von Belichtungsmasken erfolgen. Alternativ kann die Belichtung 7 über eine sogenannte Projektionsbelichtung erfolgen, in der der Abbildungsmaßstab der abgebildeten Belichtungsmaske 4 durch die Abbildungsoptik entsprechend an die Geometrie des Grundkörpers 11 angepasst wird.

Alternativ können einzelne Bereiche des photoempfindlichen Materials 2 gezielt belichtet werden. Beispielsweise können die zu belichtenden Bereiche gezielt abgefahren werden. Dies kann zum Beispiel mit einem Laser erfolgen. Man spricht dabei von Laserlithografie. Beim Laserlithografieverfahren handelt es sich in der Regel um ein maskenloses Belichtungsverfahren.

Durch die Belichtung 7 ergibt sich die in Figur 2B gezeigte strukturierte Anordnung des photoempfindlichen Materials 2. Das photoempfindliche Material 2 ist so strukturiert, dass jede erste interne Elektrodenschicht 5a auf einer Außenseite 10a mit photoempfindlichem Material 2 bedeckt ist, und jede zweite interne Elektrodenschicht 5b frei von photoempfindlichem Material 2 ist. Auf der Außenseite 10b sind analog die anderen internen Elektrodenschichten 5a, 5b mit photoempfindlichem Material bedeckt bzw. frei von photoempfindlichem Material (nicht dargestellt).

Anschließend wird auf die freiliegenden zweiten internen Elektrodenschichten 5b Isoliermaterial 3 aufgetragen, wie in Figur 2C gezeigt. Das Isoliermaterial 3 kann beispielsweise Glas, Keramikpulver oder organisches Isoliermaterial enthalten. Das Isoliermaterial 3 kann beispielsweise mittels Bedruckens, Sprühens, Sputterns oder Gasphasenabscheidung aufgebracht werden. Das Isoliermaterial 3 und das photoempfindliche Material 2 sind unterschiedliche Materialien.

Daraufhin werden die ersten internen Elektrodenschichten 5a, die zur Kontaktierung durch eine Außenelektrode 8 vorgesehen sind, von dem photoempfindlichen Material 2 befreit. Unter Umständen ist vor dem Entfernen des photoempfindlichen Materials 2 ein zusätzlicher Prozessschritt notwendig, der sicherstellt, dass das photoempfindliche Material 2 nicht mit Isoliermaterial 3 bedeckt ist, wie in Figur 2D gezeigt. Solch überschüssiges Isoliermaterial 3 kann beispielsweise durch Abziehen, Polieren, Sandstrahlen, Schleifen oder Fräsen entfernt werden.

Das photoempfindliche Material 2 über den zur Kontaktierung durch eine Außenelektrode 8 vorgesehenen ersten Elektrodenschichten 5a kann beispielsweise in einem sogenannten Lift-Off-Verfahren entfernt werden. Dabei wird das photoempfindliche Material 2 so entwickelt, dass eine negative Flanke entsteht, wodurch ein Abschattungseffekt für das aufgebrachte Isoliermaterial 3 entsteht. Beim Aufbringen des Isoliermaterials 3 bleibt die negative Flanke frei von Isoliermaterial 3. An dieser Flanke kann anschließend ein Lösungsmittel angreifen, wodurch das photoempfindliche Material 2 mit dem darauf haftenden Isoliermaterial 3 gemeinsam entfernt werden kann.

Wie in Figur 2E gezeigt, ist nun jede zweite interne Elektrodenschicht 5b mit Isoliermaterial 3 bedeckt. Die übrigen internen Elektrodenschichten 5a liegen frei.

Nun wird, wie in Figur 2F gezeigt, elektrisch leitfähiges Material 6 auf der ersten Außenseite 10a aufgetragen. Dabei wird jede freiliegende erste interne Elektrodenschicht 5a mit elektrisch leitfähigem Material 6 bedeckt, die zweiten internen Elektrodenschichten 5b sind durch das Isoliermaterial 3 abgedeckt. Auf der gegenüberliegenden Außenseite 10b werden gleichermaßen die zweiten internen Elektrodenschichten 5b mit elektrisch leitfähigem Material und die ersten internen Elektrodenschichten 5a mit Isoliermaterial bedeckt.

Das elektrisch leitfähige Material 6 kann zum Beispiel eine Metallpaste oder ein Leitkleber sein. Das elektrisch leitfähige Material 6 wird vorzugsweise eingebrannt oder ausgehärtet. Anschließend wird eine erste Außenelektrode 8a an der ersten Außenseite 10a angebracht. Die erste Außenelektrode 8a ist über das elektrisch leitfähige Material 6 auf der ersten Außenseite 10a mit jeder ersten internen Elektrodenschicht 5a verbunden und von den anderen internen Elektrodenschichten 5b isoliert. Auf der gegenüberliegenden zweiten Außenseite 10b ist die zweite Außenelektrode 8b mit jeder zweiten internen Elektrodenschicht 5b verbunden und von den ersten internen Elektrodenschichten 5a isoliert.

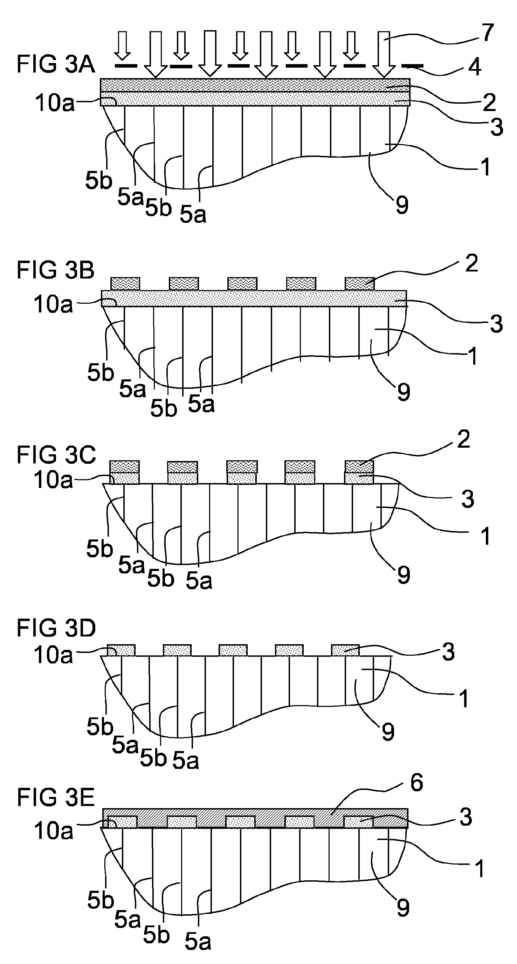

Die Figuren 3A bis 3E zeigen ein Prinzipschema für ein alternatives Herstellungsverfahren zur Herstellung des in Figur 1 gezeigten piezoelektrischen Vielschichtbauelements 1 mittels photoempfindlichen Materials 2.

Auf einer ersten Außenseite 10a des Grundkörpers 11 wird zunächst Isoliermaterial 3 aufgetragen. Das Isoliermaterial 3 ist beispielsweise als Glas-Coating ausgebildet. Anschließend wird photoempfindliches Material 2 auf das Isoliermaterial 3 aufgetragen. Mit einer individuell angepassten Belichtungsmaske 4 wird das photoempfindliche Material 2 durch eine Belichtung 7 gemäß dem Prinzip der optischen Lithografie strukturiert. Beispielsweise lösen sich belichtete Bereiche des photoempfindlichen Materials 2 auf.

Alternativ können belichtete Bereiche des photoempfindlichen Materials 2 mit einem Lösungsmittel A entfernt werden, welches zum Beispiel die belichteten, nicht jedoch die unbelichteten Bereiche des photoempfindlichen Materials 2 auflöst.

Das photoempfindliche Material 2 wird, wie in Figur 3B gezeigt, auf der ersten Außenseite 10a so strukturiert, dass ein Streifen aus photoempfindlichem Material 2 über jeder zweiten internen Elektrodenschicht 5b vorhanden ist während sich über den ersten internen Elektrodenschichten 5a kein photoempfindliches Material befindet. Die unter dem photoempfindlichen Material 2 aufgebrachte Schicht aus Isoliermaterial 3 bleibt bis dahin unverändert.

Das Isoliermaterial 3 wird, wie in Figur 3C gezeigt, in einem nachfolgenden Schritt an den von photoempfindlichem Material 2 befreiten Stellen ebenfalls entfernt. Dadurch wird erreicht, dass jede erste interne Elektrodenschicht 5a freiliegt, und jede zweite interne Elektrodenschicht 5b mit Isoliermaterial 3 und photoempfindlichem Material 2 bedeckt ist. Auf einer zweiten Außenseite 10b werden gleichermaßen die zweiten internen Elektrodenschichten 5b freigelegt.

Die Entfernung des Isoliermaterials 3 erfolgt zum Beispiel über ein Ätzmedium, welches zwar das Isoliermaterial 3, nicht aber das photoempfindliche Material 2 ätzt. Somit dient das photoempfindliche Material 2 als Maske für die gezielte Entfernung des Isoliermaterials 3. Alternativ kann das Isoliermaterial 3 eine Mischung aus Glaspulver und Binder enthalten, welche zum Beispiel durch ein Lösungsmittel B angelöst werden kann. Das Lösungsmittel B kann beispielsweise Wasser sein. Das photoempfindliche Material 2 kann in Lösungsmittel B nicht angelöst werden.

Im nächsten Verfahrensschritt wird das photoempfindliche Material 2 vollständig entfernt. Zum Beispiel kann das photoempfindliche Material 2 mechanisch mittels Sandstrahlen, Schleifen oder Fräsen entfernt werden. Alternativ kann das photoempfindliche Material 2 zum Beispiel durch ein Lösungsmittel C entfernt werden. Das Lösungsmittel C kann zum Beispiel die unbelichteten Bereiche des photoempfindlichen Materials 2, nicht jedoch das Isoliermaterial 3 auflösen. Die beschriebenen Lösungsmittel A, B und C sind vorzugsweise unterschiedliche Lösungsmittel, die die verschiedenen Materialien selektiv entfernen. Beispielsweise ist eines der Lösungsmittel A, B oder C Wasser.

Dadurch erhält man die in Figur 3D gezeigte Zwischenstufe, bei dem alternierend jede zweite interne Elektrodenschicht 5b mit Isoliermaterial 3 bedeckt ist. Die ersten internen Elektrodenschichten 5a liegen frei.

In einem darauffolgenden Verfahrensschritt wird elektrisch leitfähiges Material 6, zum Beispiel eine Metallpaste, auf die erste Außenseite 10a des Grundkörpers 11 aufgebracht. Dadurch wird jede erste interne Elektrodenschicht 5a mit elektrisch leitfähigem Material 6 bedeckt. Die zweiten internen Elektrodenschichten 5b sind von Isoliermaterial 3 bedeckt. Das elektrisch leitfähige Material 6 wird anschließend entbindert und eingebrannt. Auf der gegenüberliegenden zweiten Außenseite 10b werden die zweiten internen Elektrodenschichten 5b mit elektrisch leitfähigem Material 6 bedeckt, während die ersten internen Elektrodenschichten 5a mit Isoliermaterial 3 bedeckt sind (nicht dargestellt).

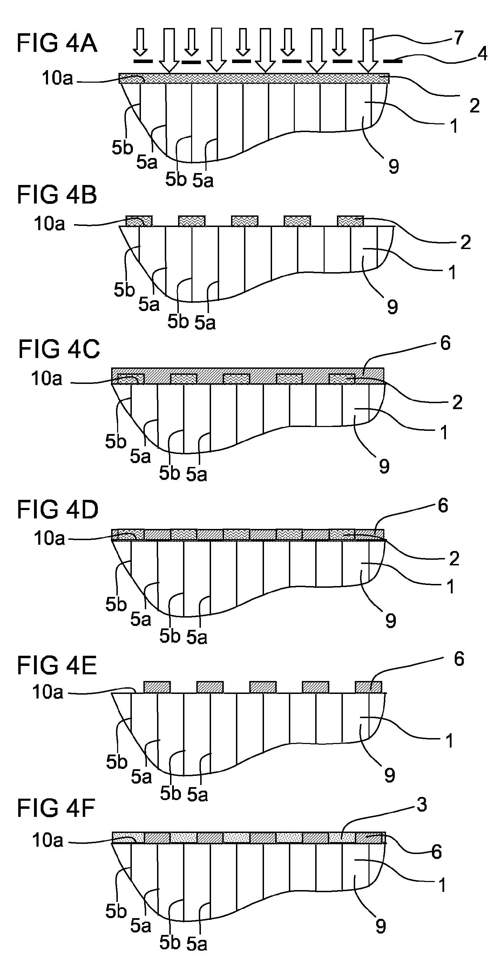

Die Figuren 4A bis 4F zeigen ein Prinzipschema für ein weiteres Herstellungsverfahren zur Herstellung des in Figur 1 gezeigten piezoelektrischen Vielschichtbauelements 1 mittels photoempfindlichen Materials 2. Dieses Herstellungsverfahren verläuft ähnlich zu dem Herstellungsverfahren gemäß der Figuren 2A bis 2F, mit dem Unterschied, dass das elektrisch leitfähige Material 6 vor dem Isoliermaterial 3 aufgetragen wird.

Zunächst wird, wie in Figur 4A gezeigt, ein photoempfindliches Material 2 auf eine erste Außenseite 10a des Grundkörpers 11 eines Vielschichtbauelements 1 aufgetragen. Anschließend wird durch eine Belichtung 7 über eine Belichtungsmaske 4 gemäß dem Prinzip der optischen Lithografie das photoempfindliche Material 2 strukturiert.

Wie in Figur 4B gezeigt, wird das photoempfindliche Material 2 so strukturiert, dass jede zweite interne Elektrodenschicht 5b mit photoempfindlichem Material 2 bedeckt ist.

Anschließend wird elektrisch leitfähiges Material 6 auf die freiliegenden ersten internen Elektrodenschichten 5a aufgetragen. Das elektrisch leitfähige Material 6 ist beispielsweise eine Metallisierungspaste, welche auf die selektiv mit photoempfindlichem Material 2 versehene erste Außenseite 10a aufgetragen wird. Alternativ kann die selektiv mit photoempfindlichem Material 2 versehene erste Außenseite 10a zum Beispiel mittels Bedruckens, Sprühens, Sputterns oder chemischer Gasphasenabscheidung mit elektrisch leitfähigem Material 6, beispielsweise mit einem metallischen Material, beschichtet werden.

In einem darauffolgenden Verfahrensschritt wird das übrige photoempfindliche Material 2 beispielsweise in einem Lift-Off Verfahren entfernt. Das an dem photoempfindlichen Material 2 haftende elektrisch leitfähige Material 6 wird dabei ebenfalls entfernt. Unter Umständen ist vor dem Entfernen des photoempfindlichen Materials 2 ein zusätzlicher Prozessschritt notwendig, der sicherstellt, dass das photoempfindliche Material 2 nicht mit elektrisch leitfähigem Material 6 bedeckt ist, wie in Figur 4D gezeigt. Solch überschüssiges elektrisch leitfähiges Material 6 kann beispielsweise durch Sandstrahlen, Schleifen oder Fräsen entfernt werden. Alternativ kann das überschüssige elektrisch leitfähige Material durch Läppen entfernt werden.

Wie in Figur 4E gezeigt, ist nun jede erste interne Elektrodenschicht 5a mit elektrisch leitfähigem Material 6 bedeckt, während die zweiten internen Elektrodenschichten 5b freiliegen.

Anschließend wird, wie in Figur 4F gezeigt, Isoliermaterial 3 in die Gräben über den freiliegenden zweiten internen Elektrodenschichten 5b gefüllt. Das Isoliermaterial 3 weist dabei beispielsweise ein unterschiedliches Haftverhalten an Metall und an Keramik auf. Dadurch haftet das Isoliermaterial 3 selektiv an jeder zweiten, nicht mit elektrisch leitfähigem Material 6 bedeckten internen Elektrodenschicht 5b. Das elektrisch leitfähige Material 6 ist nicht von Isoliermaterial 3 bedeckt.

Nach demselben Vorgehen werden auf der gegenüberliegenden zweiten Außenseite 10b die zweiten internen Elektrodenschichten 5b mit elektrisch leitfähigem Material und die ersten internen Elektrodenschichten 5a mit Isoliermaterial bedeckt (nicht dargestellt).

Anschließend werden zwei Außenelektroden zur elektrischen Kontaktierung der mit elektrisch leitfähigem Material 6 bedeckten internen Elektrodenschichten 5a, 5b angebracht. Die Außenelektroden werden an den gegenüberliegenden Außenseiten 10a, 10b des Vielschichtbauelements 1 angebracht. Beispielsweise werden die Außenelektroden angelötet.

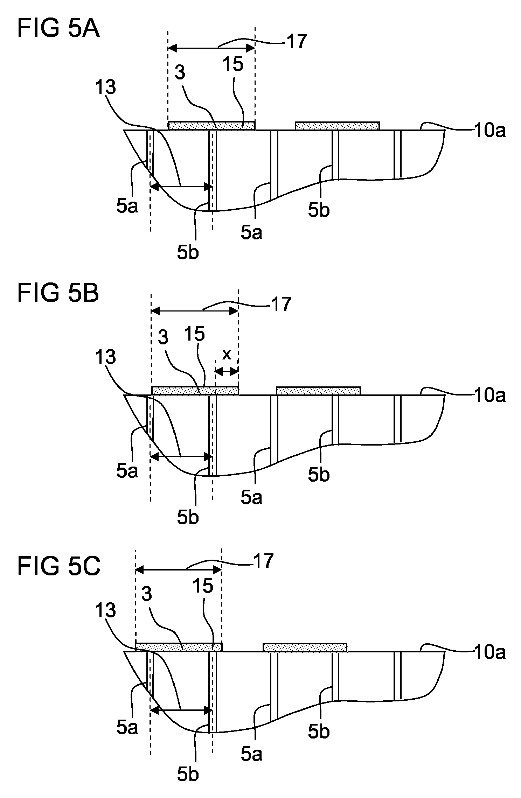

Die Figuren 5A bis 5C zeigen jeweils in einer Seitenansicht einen Ausschnitt eines piezoelektrischen Bauelements, wobei jeweils eine unterschiedliche Positionierung eines Isolationsstegs 15 auf einer internen Elektrodenschicht 5a gezeigt ist. Solche unterschiedlichen Positionierungen können insbesondere dann zustande kommen, wenn sich aufgrund von Toleranzen beim Herstellungsprozess unterschiedliche Abstände 13 der internen Elektrodenschichten 5a, 5b ergeben, und die Struktur der Belichtungsmaske 4 nicht genau mit der Anordnung der internen Elektrodenschichten 5a, 5b übereinstimmt.

Figur 5A zeigt einen Idealfall, wobei ein Isolationssteg 15 mittig über jeder zweiten internen Elektrodenschicht 5b auf einer Außenseite 10a angeordnet ist, so dass jede zweite interne Elektrodenschicht 5b isoliert ist. Die Breite 17 des Isolationssteges 15 ist größer als der Abstand 13 zwischen zwei benachbarten internen Elektrodenschichten. Beispielsweise ist die Breite 17 um den Faktor 1,3 bis 1,5 größer als die Breite des Kontaktstegs 16. Jede erste interne Elektrodenschicht 5a auf der Außenseite 10a kann elektrisch kontaktiert werden.

Figur 5B zeigt einen Grenzfall, wobei der Isolationssteg 15 nicht mehr mittig über einer zweiten Elektrodenschicht 5b angeordnet ist, aber eine Kontaktierung der ersten internen Elektrodenschichten 5a auf einer Außenseite 10a gerade noch erreicht wird. Der Isolationssteg 15 ist über einer zweiten internen Elektrodenschicht 5b so angeordnet, dass er die benachbarte erste interne Elektrodenschicht 5a gerade nicht bedeckt. Somit ist eine Kontaktierung der ersten internen Elektrodenschicht 5a möglich. Der Isolationssteg 15 ist dabei um die Breite x breiter als der Abstand 13 zwischen zwei benachbarten internen Elektrodenschichten 5a, 5b.

Die Breite x berechnet sich vorzugsweise nach der Formel x = (d_{E} - d_{K}), wobei d_{E} der Abstand 13 zweier interner Elektrodenschichten 5a, 5b und d_{K} die Breite des Kontaktstegs 16 in Stapelrichtung sind. Die Breite x beträgt beispielsweise wenigstens 1/21-mal den Abstand 13 zweier benachbarter interner Elektrodenschichten 5a, 5b, entsprechend einem Isolationssteg der 1,1-mal so breit ist wie ein Kontaktsteg. Die Breite x beträgt beispielsweise bis zu 1/3-mal den Abstand 13 zweier benachbarter interner Elektrodenschichten 5a, 5b, entsprechend einem Isolationssteg der 2-mal so breit ist wie ein Kontaktsteg. Die Breite x beträgt beispielsweise 3/23 bis 1/5-mal den Abstand 13 zweier benachbarter interner Elektrodenschichten 5a, 5b, entsprechend einem Isolationssteg der 1,3 bis 1,5-mal so breit ist wie ein Kontaktsteg. Durch diesen Überlapp kann trotz der außermittigen Positionierung des Isolationsstegs 15 noch eine Isolierung der internen Elektrodenschicht 5b erreicht werden, so dass das Bauelement noch zuverlässig funktionieren kann.

Die unsymmetrische Anordnung des Isolationsstegs 15 über der zweiten internen Elektrodenschicht 5b kann durch ungleichmäßige Abstände 13 der internen Elektrodenschichten 5a, 5b hervorgerufen sein. Diese ungleichmäßigen Abstände können beispielsweise durch Pressverzug oder unterschiedlichen Sinterschwund während dem Herstellungsprozess zustande kommen.

Figur 5C zeigt einen Fall, wobei eine Kontaktierung der ersten internen Elektrodenschichten 5a auf einer Außenseite 10a nicht mehr möglich ist. Der Isolationssteg 15 ist so auf der Außenseite 10a angeordnet, dass durch den Isolationssteg 15 zwei benachbarte interne Elektrodenschichten 5a, 5b mit Isoliermaterial 3 bedeckt sind. Bei Auftreten einer derartigen Fehlkontaktierung kann die Funktionsfähigkeit eines Vielschichtbauelements eingeschränkt sein. Solche fehlerhaften Bauelemente können mit einer Messung leicht ermittelt werden und werden als Ausschuss aussortiert.

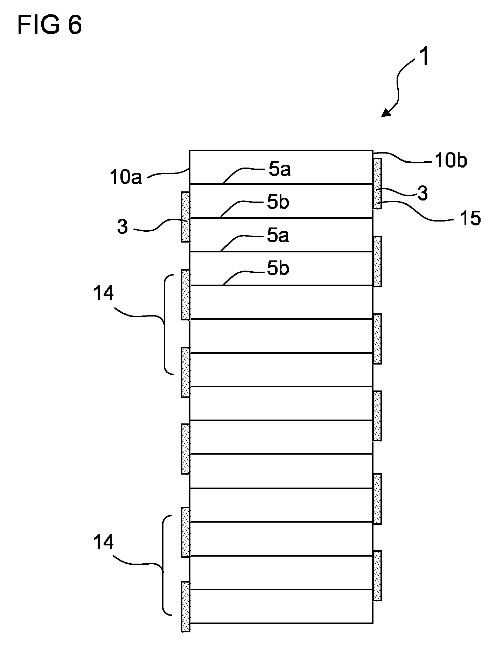

Figur 6 zeigt ein Vielschichtbauelement 1 mit nicht kontaktierten Bereichen 14 in einer Seitenansicht. Aufgrund von unterschiedlichen Abständen zwischen den internen Elektrodenschichten 5a, 5b werden auf einer Außenseite 10a, 10b mehrere benachbarte interne Elektrodenschichten 5a, 5b mit Isoliermaterial bedeckt. Beispielsweise werden interne Elektrodenschichten 5a, 5b auf beiden Außenseiten 10a, 10b von Isoliermaterial 3 bedeckt. Dadurch entstehen nicht kontaktierte Bereiche 14. Ein Bauelement mit nicht kontaktierten Bereichen 14 ist fehlerhaft und kann durch eine Messung identifiziert und aussortiert werden. Somit kann ein Ausfall während des Betriebes verhindert werden.

### Bezugszeichen

- 1: Vielschichtbauelement
- 2: photoempfindliches Material
- 3: Isoliermaterial
- 4: Belichtungsmaske
- 5a: erste interne Elektrodenschicht
- 5b: zweite interne Elektrodenschicht
- 6: elektrisch leitfähiges Material
- 7: Belichtung
- 8a: erste Außenelektrode
- 8b: zweite Außenelektrode
- 9: piezoelektrische Schicht
- 10a: erste Außenseite
- 10b: zweite Außenseite
- 10c: dritte Außenseite
- 10d: vierte Außenseite
- 11: Grundkörper
- 12: Stapelrichtung
- 13: Abstand zweier benachbarter interner Elektrodenschichten
- 14: Nicht kontaktierter Bereich
- 15: Isolationssteg
- 16: Kontaktsteg
- 17: Breite des Isolationsstegs
- x: Überlapp

## Patentansprüche

1. Verfahren zur Herstellung einer elektrischen Kontaktierung eines Vielschichtbauelements umfassend die Schritte:
A) Bereitstellen eines Grundkörpers (11) des Vielschichtbauelements (1) mit internen Elektrodenschichten (5a, 5b),
B) Bereitstellen eines Isoliermaterials (3), eines elektrisch leitfähigen Materials (6) und eines photoempfindlichen Materials (2),
C) Strukturierte Anordnung von Isoliermaterial (3) und elektrisch leitfähigem Material (6) auf einer Außenseite (10a, 10b) des Grundkörpers (11) zur abwechselnden Kontaktierung der internen Elektrodenschichten (5a, 5b), wobei die strukturierte Anordnung durch das photoempfindliche Material (2) hergestellt wird,
**gekennzeichnet dadurch, dass**
zuerst das elektrisch leitfähige Material(6) ,dann das photoempfindliche Material (2) und danach das Isoliermaterial (3) aufgetragen wird.

2. Verfahren nach Anspruch 1, umfassend den Schritt:
Auftragung und Strukturierung des photoempfindlichen Materials (2) auf dem elektrisch leitfähigen Material (6).

3. Verfahren nach Anspruch 2,
wobei das photoempfindliche Material (2) mittels Lithografie strukturiert wird.

4. Verfahren nach einem der Ansprüche 1 bis 3, umfassend den Schritt:
Strukturierung des elektrisch leitfähigen Materials (6).

5. Verfahren nach Anspruch 4, wobei bei der Strukturierung des elektrisch leitfähigen Materials (6) das photoempfindliche Material (2) als Ätzstopp fungiert.

6. Verfahren nach einem der Ansprüche 1 bis 5, wobei die strukturierte Anordnung mittels drei verschiedener Lösungsmittel erfolgt, die die verschiedenen Materialien selektiv entfernen.

7. Verfahren nach Anspruch 6, wobei eines der Lösungsmittel Wasser ist.

8. Verfahren nach einem der Ansprüche 1 bis 7, wobei das photoempfindliche Material (2) während des Verfahrens vollständig entfernt wird.

9. Verfahren nach einem der Ansprüche 1 bis 8, wobei das Isoliermaterial (3) in Form von Isolationsstegen (15) auf die internen Elektrodenschichten (5a, 5b) aufgetragen wird, wobei die jeweilige Breite (17) der Isolationsstege in Stapelrichtung größer ist als ein Abstand (13) zweier benachbarter interner Elektrodenschichten (5a, 5b).

10. Vielschichtbauelement nach Anspruch 9,
wonach auf einer Außenseite (10a, 10b) des Grundkörpers (11) jeweils eine Vielzahl von Isolationsstegen (15) angeordnet ist.

11. Verfahren nach einem der vorhergehenden Ansprüche, umfassend den Schritt:
Vermessen des Grundkörpers (11) zur Ermittlung der Lage der internen Elektrodenschichten (5a, 5b) vor der Strukturierung des photoempfindlichen Materials (2).

12. Verfahren nach dem vorhergehenden Anspruch,
wobei das photoempfindliche Material (2) mittels einer Belichtungsmaske durch eine Belichtung strukturiert wird, wobei die Belichtungsmaske entsprechend dem Ergebnis der Vermessung des Grundkörpers (11) ausgewählt ist.

13. Verfahren nach einem der vorhergehenden Ansprüche,
wobei das Isoliermaterial (3) und das elektrisch leitfähige Material (6) nach der Strukturierung abwechselnd streifenförmig über den internen Elektrodenschichten (5a, 5b) angeordnet sind.

## Claims

1. Method for producing an electric contact-connection of a multilayer component comprising the following steps:
A) providing a main body (11) of the multilayer component (1) having internal electrode layers (5a, 5b),
B) providing an insulating material (3), an electrically conductive material (6) and a photosensitive material (2),
C) structured arrangement of insulating material (3) and electrically conductive material (6) on an outer side (10a, 10b) of the main body (11) for the alternate contact-connection of the internal electrode layers (5a, 5b), wherein the structured arrangement is produced by the photosensitive material (2), **characterized in that** first of all the electrically conductive material (6) is applied, then the photosensitive material (2) is applied and then the insulating material (3) is applied.

2. Method according to Claim 1, comprising the following step:
applying and structuring the photosensitive material (2) on the electrically conductive material (6).

3. Method according to Claim 2,
wherein the photosensitive material (2) is structured by means of lithography.

4. Method according to any of Claims 1 to 3, comprising the following step:
structuring the electrically conductive material (6).

5. Method according to Claim 4,
wherein, during the structuring of the electrically conductive material (6), the photosensitive material (2) functions as an etching stop.

6. Method according to any of Claims 1 to 5, wherein the structured arrangement is effected by means of three different solvents, which selectively remove the different materials.

7. Method according to Claim 6, wherein one of the solvents is water.

8. Method according to any of Claims 1 to 7, wherein the photosensitive material (2) is completely removed during the method.

9. Method according to any of Claims 1 to 8, wherein the insulating material (3) is applied to the internal electrode layers (5a, 5b) in the form of insulation webs (15), wherein the respective width (17) of the insulation webs in the stacking direction is greater than a distance (13) between two adjacent internal electrode layers (5a, 5b).

10. Multilayer component according to Claim 9, according to which in each case a multiplicity of insulation webs (15) are arranged on an outer side (10a, 10b) of the main body (11).

11. Method according to any of the preceding claims, comprising the following step:
measuring the main body (11) for determining the position of the internal electrode layers (5a, 5b) before the structuring of the photosensitive material (2).

12. Method according to the preceding claim,
wherein the photosensitive material (2) is structured by an exposure by means of an exposure mask, wherein the exposure mask is selected in accordance with the result of the measurement of the main body (11).

13. Method according to any of the preceding claims,
wherein the insulating material (3) and the electrically conductive material (6) are arranged alternately in strip-shaped fashion above the internal electrode layers (5a, 5b) after the structuring.

## Revendications

1. Procédé de production d'une connexion électrique d'un composant multicouche comprenant les étapes suivantes :
A) fourniture d'un corps de base (11) du composant multicouche (1) comprenant des couches d'électrode (5a, 5b) internes,
B) fourniture d'un matériau isolant (3), d'un matériau électriquement conducteur (6) et d'un matériau photosensible (2),
C) arrangement structuré du matériau isolant (3) et du matériau électriquement conducteur (6) sur un côté extérieur (10a, 10b) du corps de base (11) en vue d'une connexion en alternance des couches d'électrode (5a, 5b) internes, l'arrangement structuré étant produit par le matériau photosensible (2),
**caractérisé en ce que**
le matériau électriquement conducteur (6) est appliqué en premier, ensuite le matériau photosensible (2) et ensuite le matériau isolant (3).

2. Procédé selon la revendication 1, comprenant l'étape suivante : application et structuration du matériau photosensible (2) sur le matériau électriquement conducteur (6).

3. Procédé selon la revendication 2, selon lequel le matériau photosensible (2) est structuré au moyen de la lithographie.

4. Procédé selon l'une des revendications 1 à 3, comprenant l'étape suivante : structuration du matériau électriquement conducteur (6).

5. Procédé selon la revendication 4, selon lequel, lors de la structuration du matériau électriquement conducteur (6), le matériau photosensible (2) fait office de barrière de gravure.

6. Procédé selon l'une des revendications 1 à 5, selon lequel l'arrangement structuré est effectué au moyen de trois solvants différents qui enlèvent les différents matériaux de manière sélective.

7. Procédé selon la revendication 6, selon lequel l'un des solvants est de l'eau.

8. Procédé selon l'une des revendications 1 à 7, selon lequel le matériau photosensible (2) est totalement enlevé pendant le procédé.

9. Procédé selon l'une des revendications 1 à 8, selon lequel le matériau isolant (3) est appliqué sur les couches d'électrode (5a, 5b) internes sous la forme de nervures d'isolation (15), la largeur (17) respective des nervures d'isolation dans le sens de l'empilement étant supérieure à un écart (13) entre deux couches d'électrode (5a, 5b) internes voisines.

10. Composant multicouche selon la revendication 9, une pluralité de nervures d'isolation (15) étant ensuite respectivement disposée sur un côté extérieur (10a, 10b) du corps de base (11).

11. Procédé selon l'une des revendications précédentes, comprenant l'étape suivante : mesure du corps de base (11) en vue de déterminer la position des couches d'électrode (5a, 5b) internes avant la structuration du matériau photosensible (2).

12. Procédé selon l'une des revendications précédentes, avec lequel le matériau photosensible (2) est structuré par une exposition à la lumière à travers un masque d'exposition à la lumière, le masque d'exposition à la lumière étant sélectionné conformément au résultat de la mesure du corps de base (11).

13. Procédé selon l'une des revendications précédentes, avec lequel le matériau isolant (3) et le matériau électriquement conducteur (6) sont disposés après la structuration en alternance en forme de bandes sur les couches d'électrode (5a, 5b) internes.
